# DEMANDE DE BREVET EUROPEEN

(11) **EP 4 575 639 A1**
(43) Date de publication de la demande: **25.06.2025**
(21) Numéro de dépôt: 24220856.9
(22) Date de dépôt: 18.12.2024
(51) Int. Cl.: G03F 7/00, G03F 7/004, G03F 7/075, H01L 25/075

(54) **PROCÉDÉ DE FABRICATION DE MOTIFS À PAROIS INCURVÉES PAR PHOTOLITHOGRAPHIE**

(30) Priorité: 21.12.2023 FR 2314725
(71) Demandeur: Aledia, 38800 Champagnier (FR)
(72) Inventeur: JACQUIN, Elisabeth, 38000 GRENOBLE (FR); LINCHENEAU, Christophe, 38430 MOIRANS (FR); FUCHS, Emmanuel, 38100 GRENOBLE (FR); MOODELLY, Davina, 38360 NOYAREY (FR); PELLETIER, Barbara, 38120 Saint Egrève (FR)
(74) Mandataire: Hautier IP

(57) **Abrégé**

L'invention concerne un procédé de formation par lithographie défocalisée, d'un empilement (1) comprenant une couche photosensible (10) à base d'une résine photosensible comprenant des particules dites « diffusantes », ledit empilement (1) comprenant en outre au moins un motif (20, 20') délimité au moins en partie par une paroi latérale incurvée de sorte qu'une intersection de la paroi incurvée avec un plan sensiblement perpendiculaire au plan d'extension principale de l'empilement (1) forme une ligne courbe.

L'invention concerne également la réalisation d'un dispositif optoélectronique (100) comprenant l'empilement (1), dans lequel l'au moins un motif (20, 20') est au moins une cavité délimitée au moins en partie par ladite paroi latérale incurvée, et au moins une diode électroluminescente (50) disposée dans l'au moins une cavité (20).

## Description

### DOMAINE TECHNIQUE

La présente invention concerne le domaine de la photolithographie. Elle trouve pour application particulièrement avantageuse la fabrication de dispositifs optoélectroniques comprenant des diodes disposées dans des cavités, permettant l'amélioration des performances de ces dispositifs.

### ETAT DE LA TECHNIQUE

La photolithographie est une technique couramment utilisée pour la réalisation de microstructures dans des couches photosensibles de résine, à l'aide d'un masque présentant des régions opaques, typiquement en chrome, à un rayonnement lumineux, généralement de source UV et des régions transparentes, par exemple en quartz, laissant passer ce rayonnement. Ces régions définissent les motifs souhaités dans la couche de résine, obtenus après une étape d'insolation avec le rayonnement lumineux, suivie d'une étape de développement dans une solution adaptée. Les motifs résultants dépendent de plusieurs paramètres tels que la forme et/ou les dimensions des régions du masque, la dose d'insolation, la composition de la couche photosensible, de la polarité de la résine, etc.

Il est connu des procédés de lithographie sur des résines comprenant de l'oxyde de titane (TiO₂). Le TiOz est un semiconducteur à grand gap transparent aux longueurs d'ondes dans le visible, et qui absorbe le rayonnement ultraviolet (UV). De plus, le TiOz présente un indice de réfraction élevé ce qui fait de lui un matériau adapté à la fabrication d'éléments optiques comme des réseaux de diffraction par exemple Le phénomène de diffraction du TiO₂ dépend néanmoins de la taille de la particule. Pour la fabrication de réseaux de diffraction, le transfert des motifs du masque avec une haute résolution sur la couche de résine est généralement effectué en focalisant le faisceau du rayonnement sur la surface de la couche de résine photosensible. Des réseaux à motifs 2D, et notamment avec des parois non uniformes, peuvent être obtenus par insolations successives. Ces solutions restent en pratique complexes à mettre en oeuvre et peu modulables en termes de géométries pouvant être obtenues.

Un objet de la présente invention est donc de proposer une solution simplifiée permettant d'obtenir des motifs à paroi incurvée par photolithographie. Un objet de la présente invention peut plus particulièrement être de proposer une solution permettant d'obtenir des cavités à paroi incurvée, et notamment pour améliorer les performances de dispositifs optoélectroniques comprenant une diode.

### RESUME

Pour atteindre cet objectif, selon un premier aspect de l'invention on prévoit un procédé de fabrication par lithographie défocalisée, d'un empilement comprenant au moins un motif, de préférence une cavité, délimité au moins en partie par une paroi latérale incurvée de sorte qu'une intersection de la paroi incurvée avec un plan sensiblement perpendiculaire au plan d'extension principale de l'empilement forme une ligne courbe, le procédé comprenant :
- une fourniture d'un ensemble multicouche comprenant un substrat surmonté d'une couche photosensible, la couche photosensible présentant une surface exposée et étant à base d'une résine photosensible comprenant des particules dites « diffusantes », aptes à diffuser un rayonnement lumineux incident,
- une fourniture d'un masque comprenant au moins une région configurée pour transmettre le rayonnement lumineux incident,
- un placement du masque et de l'ensemble multicouche de façon à les espacer d'une distance D1 configurée de sorte que la surface exposée de la couche photosensible ne soit pas disposée dans un plan de focalisation du rayonnement lumineux incident,
- le masque et l'ensemble multicouche étant séparés par la distance D1, une insolation d'au moins une partie de la couche photosensible, par le rayonnement lumineux incident transmis à travers l'au moins une région, dans laquelle le rayonnement lumineux incident est diffusé latéralement par les particules au fur et à mesure d'une pénétration du rayonnement lumineux incident dans la couche photosensible, de façon à former au moins une région insolée délimitée au moins en partie par une paroi latérale incurvée, et au moins une région non-insolée,
- une formation de l'au moins un motif, de préférence une cavité dans l'ensemble multicouche, la formation comprenant un retrait de l'une parmi la région insolée et la région non-insolée, pour obtenir l'empilement.

Ces différentes étapes du procédé permettent de fabriquer sur un substrat des motifs à paroi latérale incurvée à partir d'une couche photosensible de résine, par une photolithographie dite défocalisée.

Dans la présente invention, l'intégration de particules diffusantes à la composition de la résine photosensible permet la diffusion latérale progressive du rayonnement défocalisé pénétrant la couche de résine. La synergie entre la défocalisation du rayonnement lumineux incident et sa diffusion par les particules diffusantes permet une irradiation progressive dans la couche photosensible. Cette irradiation progressive se fait au moins selon une direction incluse dans le plan d'extension principale de la couche photosensible, d'une façon homogène et continue, ce qui permet de définir une paroi latérale incurvée délimitant la région insolée. Le retrait de la région insolée ou de la région non-insolée, selon que l'on utilise une résine respectivement positive ou négative, suite à une étape de développement dans une solution, donne lieu respectivement à un plot ou une cavité à parois latérales incurvées. Selon les paramètres du procédé, et par exemple les paramètres de défocalisation, de charge de particules diffusantes, la forme de la paroi incurvée peut en outre être modulée de façon simplifiée. Notamment, la profondeur du motif peut être modulée selon les besoins.

Cette approche se distingue donc tout à fait des procédés de photolithographie conventionnels. En effet, dans ces procédés conventionnels, le masque et la couche photosensible de résine sont positionnés l'un par rapport à l'autre de façon à focaliser le rayonnement d'insolation sur la surface exposée de la couche photosensible. Des motifs à parois tranchantes droites sont généralement visés, afin d'obtenir une reproduction fidèle du motif du masque sur la couche photosensible.

Un deuxième aspect de l'invention concerne un empilement comprenant :
- un substrat surmonté d'une couche photosensible à base d'une résine photosensible comprenant des particules aptes à diffuser un rayonnement lumineux incident présentant un premier pourcentage massique,
- la couche photosensible comprenant au moins un motif délimité au moins en partie par une paroi latérale incurvée de sorte qu'une intersection de la paroi incurvée avec un plan sensiblement perpendiculaire au plan d'extension principale de l'empilement forme une ligne courbe, la couche photosensible présentant une surface exposée, et l'au moins un motif débouchant sur la surface exposée.

Cet empilement comprenant des motifs à parois latérales incurvées peut être intégré dans différents dispositifs microélectroniques selon l'application visée, et notamment à des dispositifs optoélectroniques ou dispositifs d'affichage comprenant des diodes luminescentes ou des photodiodes par exemple.

Un troisième aspect de l'invention concerne un dispositif optoélectronique comprenant l'empilement décrit précédemment, et au moins une diode électroluminescente, dans lequel le motif surmonte de préférence la diode électroluminescente. Selon un exemple, l'au moins un motif est au moins une cavité délimitée au moins en partie par la paroi latérale incurvée, et l'au moins une diode électroluminescente disposée dans l'au moins une cavité, la cavité étant configurée de sorte à exposer au moins en partie la diode électroluminescente.

L'utilisation de motifs à parois incurvées fabriqués par le procédé selon le premier aspect, et notamment de cavités, permet d'améliorer les performances de ce dispositif. Les parois incurvées et réfléchissantes des motifs, permettent notamment d'améliorer l'extraction du rayonnement lumineux émis par les diodes agencées au sein des cavités.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A, 1B, 2, 3, 5A à 5D illustrent schématiquement selon des coupes transverses xz, des étapes de fabrication d'un empilement comprenant des motifs à parois incurvées selon un premier mode de réalisation de la présente invention.
Les figures 4A et 4B illustrent schématiquement selon des coupes transverses xz, la variation de la courbure des motifs fabriqués selon la présente invention en fonction de différents paramètres.
Les figures 6A et 6B illustrent schématiquement selon des coupes transverses xz, des étapes de fabrication d'un empilement comprenant des motifs à parois incurvées selon un deuxième mode de réalisation de la présente invention.
La figure 6C illustre schématiquement selon une vue en perspective, la fabrication d'un empilement comprenant des motifs à parois incurvées selon un troisième mode de réalisation de la présente invention.
Les figures 7, 8, 9A, 9B, 10, 11 et 12 illustrent schématiquement selon des coupes transverses xz, des étapes de fabrication d'un dispositif optoélectronique comprenant des cavités à parois incurvées et des diodes électroluminescentes selon un mode de réalisation de la présente invention.
La figure 13 représente des images des cavités à parois incurvées fabriquées selon la présente invention, prises par microscopie électronique à balayage.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et/ou les dimensions des différentes couches, motifs et reliefs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la distance D1 est strictement supérieure à une distance entre le masque et le plan de focalisation.

Selon un exemple, le faisceau lumineux incident sur la couche photosensible est divergent, au moins entre le masque et la surface exposée. Le faisceau incident peut être droit ou divergent entre la source du faisceau lumineux et le masque.

Selon un exemple, la distance entre le masque et le plan de focalisation est choisie de sorte que la surface exposée soit écartée du plan de focalisation d'une distance D2 comprise entre 100 nm et 100 µm, de préférence entre 10 µm et 100 µm.

La distance D2 permet de contrôler la pente des parois latérales des motifs. Quand le rayonnement lumineux incident est focalisé sur la surface exposée de la couche photosensible et en absence de particules diffusantes, les parois des motifs obtenues sont tranchantes et droites. Plus la couche photosensible est loin du plan de focalisation, plus le rayonnement lumineux incident diverge, tout en restant droit, en pénétrant la couche photosensible, et plus la pente de la paroi latérale incurvée du motif obtenu a tendance à être faible. La présence de particules diffusantes dans la couche photosensible permet quant à elle la courbure des parois. Selon un exemple, le rayonnement lumineux incident est diffusé latéralement en pénétrant dans la couche photosensible de sorte à former un gradient de diffusion dont la section, dans un plan perpendiculaire à une direction principale de propagation du rayonnement lumineux incident, augmente au fur et à mesure d'une pénétration du rayonnement lumineux incident dans la couche photosensible.

Selon un exemple, l'au moins un motif présente dans le plan d'extension principale de l'empilement, une section transversale uniquement croissante ou uniquement décroissante, de préférence strictement, le long d'une direction perpendiculaire au plan d'extension principale de l'empilement en s'éloignant du substrat.

Selon un exemple, et comme il ressort directement de la description, l'au moins un motif présente dans le plan d'extension principale de l'empilement, une section transversale d'aire croissante, et plus particulièrement strictement croissante, le long d'une direction perpendiculaire au plan d'extension principale de l'empilement en s'éloignant du substrat. De façon équivalente, l'au moins un motif présente dans le plan d'extension principale de l'empilement, une section transversale d'aire décroissante, et plus particulièrement strictement décroissante, le long d'une direction perpendiculaire au plan d'extension principale de l'empilement en direction du substrat. Le motif formé présente ainsi une forme évasée plus on s'éloigne du substrat. Ceci se distingue de cavité présentant une section avec restriction de diamètre, ou de façon équivalente présentant une section croissante puis décroissante le long d'une direction perpendiculaire au plan d'extension principale de l'empilement en direction du substrat, qui limite l'extraction de la lumière. Ladite section transversale peut être circulaire. On comprend donc que le diamètre du motif peut être décroissant le long d'une direction perpendiculaire au plan d'extension principale de l'empilement et en direction du substrat.

Selon un exemple, la couche photosensible est à base d'une résine négative et l'au moins un motif obtenu est au moins une cavité.

Selon un autre exemple, la couche photosensible est à base d'une résine positive et l'au moins un motif obtenu est au moins un plot.

Selon un exemple, les particules diffusantes sont choisies parmi le groupe constitué de : des oxydes de métaux de formule MₓO_{y}, avec x, y des entiers positifs non nuls, tels que le dioxyde de titane (TiO₂), l'oxyde de zinc (ZnO), l'oxyde de manganèse (MnO), les oxydes de lanthanides (Ln₂O₃), l'oxyde d'aluminium (Al₂O₃), l'oxyde de magnésium (MgO), l'oxyde de silicium (SiOz), les oxydes de fer (FeₓO_{y}), l'oxyde de zirconium (ZrOz), et des nanoparticules à base d'au moins un métal tel que l'argent (Ag), l'or (Au), le platine (Pt), le nickel (Ni), l'aluminium (AI) ou le chrome (Cr).

Ces particules diffusantes permettent d'une part, la diffusion du rayonnement lumineux incident dans la couche photosensible lors de l'étape d'insolation. D'autre part, grâce à la bonne réflectivité des matériaux métalliques, les particules diffusantes à base de ces matériaux permettent la réflexion d'un rayonnement lumineux incident à la paroi du motif résultant.

La diffusion du rayonnement lumineux incident dans la couche photosensible varie selon la nature des particules diffusantes ainsi que leur dimension. La dimension de ces particules diffusantes est généralement du même ordre que la longueur d'onde du rayonnement lumineux incident.

Selon un exemple, les particules diffusantes sont aptes à diffuser un rayonnement lumineux incident de longueur d'onde dans l'ultraviolet égale à 365 nm, 248 nm ou 193 nm.

Selon un exemple, la couche photosensible est à base d'une résine photosensible négative, de sorte que, lors de la formation de l'au moins un motif, le retrait de la région non-insolée induise la formation d'au moins une cavité délimitée au moins en partie par la paroi latérale incurvée. L'exposition d'une résine négative à un rayonnement lumineux d'insolation permet la réticulation de la région insolée de la couche photosensible de résine. La diffusion latérale progressive du rayonnement d'insolation par les particules diffusantes présentes dans la couche photosensible, permet de définir une région non-insolée délimitée par des parois latérales incurvées. Une intersection de ces parois avec un plan sensiblement perpendiculaire au plan d'extension principale de la couche photosensible, forme des lignes courbes. Les rayons de courbure de ces lignes courbes s'étendent dans la région non-insolée.

Lors de l'étape de développement, en partant d'une résine négative, la région non-insolée est dissoute formant ainsi une cavité. La courbure des parois de cette cavité présente un rayon de courbure qui s'étend au moins en partie dans la cavité.

Dans le cas d'une résine positive, la région insolée est dissoute lors du développement formant ainsi un plot. Le plot formé présente une paroi latérale incurvée dont le rayon de courbure s'étend au moins en partie dans le plot. La stabilité du plot peut être améliorée en jouant sur les paramètres qui contrôlent la courbure ou la pente des parois incurvées.

Selon un exemple, et notamment lorsque la résine est une résine positive, la formation de l'au moins une cavité, comprend un retrait de la région insolée par dissolution lors du développement et le moulage d'une couche additionnelle sur la couche photosensible, de façon à former l'au moins une cavité dans la couche additionnelle. On comprend alors que le plot formé dans la couche photosensible sert d'empreinte pour la formation de l'au moins une cavité. En d'autres termes, l'au moins une cavité peut être obtenue *in fine* en reportant la forme du plot formé suite au développement de la résine photosensible positive dans une couche additionnelle.

Selon un exemple, la résine photosensible présente une proportion massique de particules diffusantes comprise entre 1% et 40%, de préférence entre 3% et 20%.

Selon un exemple, la proportion massique des particules diffusantes est prise par rapport à la masse totale à l'état solide de la couche photosensible.

Le pourcentage massique des particules diffusantes présentes dans la couche photosensible est un paramètre particulièrement avantageux pour contrôler la pente ou la courbure des parois des motifs. Plus la résine est chargée en particules diffusantes, plus le rayonnement lumineux incident est diffusé latéralement dans la couche photosensible, ce qui résulte en une faible pente de la paroi. En outre, le pourcentage massique des particules diffusantes joue sur la réflectivité des parois des motifs. Plus la résine est chargée en particules diffusantes, plus la réflectivité des parois est importante.

Selon un exemple, les particules diffusantes présentent une réflectivité comprise entre 20% et 100%, de préférence entre 75% et 100%.

Selon un exemple, la réflectivité des particules diffusantes peut être contrôlée en variant la dimension des particules diffusantes, leur proportion massique et la longueur d'onde du rayonnement lumineux incident.

Dans le cas d'un dispositif optoélectronique, la disposition d'une diode électroluminescente au sein d'une cavité à parois réfléchissantes permet la réduction des pertes du rayonnement émis par les diodes. La réflectivité de ces parois est donc avantageusement optimisée pour être maximale.

Selon un exemple, l'épaisseur de la couche photosensible est comprise entre 5 µm et 100 µm.

Selon un exemple, l'épaisseur de la couche photosensible peut être avantageusement adaptée pour une application d'un dispositif optoélectronique comprenant des diodes électroluminescentes.

Selon un exemple, la couche photosensible comprend plusieurs sous-couches au moins en partie superposées.

Selon un exemple, les sous-couches de la couche photosensible sont à base d'une résine photosensible négative.

Selon un exemple, au moins deux sous-couches présentent une proportion massique en particules diffusantes distincte entre elles, et de préférence chaque sous-couche présente une proportion massique en particules diffusantes distincte entre les plusieurs sous-couches.

Selon un exemple, la proportion massique en particules diffusantes augmente entre deux sous-couches superposées, et de préférence successivement superposées, en s'éloignant de la surface exposée.

Selon un exemple, les sous-couches de la couche photosensible sont à base d'une résine photosensible positive.

Selon un exemple, la proportion massique en particules diffusantes diminue entre deux sous-couches superposées, et de préférence successivement superposées, en s'éloignant de la surface exposée.

La pente des parois latérales incurvées des motifs peut aussi être modulée en partant d'un ensemble multicouche de plusieurs sous-couches de résines et en variant le pourcentage massique des particules diffusantes d'une sous-couche à l'autre, selon qu'elles soient à base d'une résine négative ou positive.

Selon un exemple, l'au moins une région insolée est soumise à une dose d'insolation comprise entre 50 mJ/cm² et 3000 mJ/cm².

La dose d'insolation permet de contrôler la profondeur et les dimensions des motifs.

Selon un exemple, la couche photosensible est à base d'une résine photosensible négative, le substrat de l'empilement est surmonté d'au moins une diode électroluminescente disposée à l'interface entre le substrat et la couche photosensible, et l'insolation est configurée de sorte que la cavité expose au moins en partie l'au moins une diode électroluminescente.

Les cavités à parois incurvées réfléchissantes, permettent l'amélioration de l'extraction du rayonnement émis par les diodes électroluminescentes.

Selon un exemple, le procédé comprend, après la formation de l'au moins une cavité, le dépôt d'une solution comprenant un module de conversion de couleur dans l'au moins une cavité exposant l'au moins une diode électroluminescente.

L'introduction de modules de conversion de couleur au sein des cavités permet une conversion de la longueur d'onde du rayonnement lumineux émis par la diode électroluminescente. La longueur d'onde de la lumière réémise par les modules de conversion de couleur dépend de la taille et de la composition de ces modules de conversion de couleur.

Selon un exemple, la diode électroluminescente étant configurée pour émettre un rayonnement lumineux présentant une première longueur d'onde, les modules de conversion de couleur sont configurés pour convertir la première longueur d'onde en une deuxième longueur d'onde distincte de la première longueur d'onde.

Selon un exemple, les modules de conversion peuvent comprendre des luminophores, ou des particules photoluminescentes. Selon un exemple, les particules photoluminescentes sont dispersées dans une matrice transparente, par exemple à base d'une résine photosensible. Selon un exemple, les particules photoluminescentes sont des boîtes quantiques.

Selon un exemple, la solution comprenant des modules de conversion de couleur, comprend en outre des particules diffusantes, aptes à diffuser un rayonnement émis par l'au moins une diode électroluminescente.

Selon un exemple, la solution comprenant des modules de conversion de couleur, présente une proportion massique en particules diffusantes inférieure à une proportion massique des particules diffusantes dans la couche photosensible.

Selon un exemple, la solution comprenant des modules de conversion de couleur, présente une proportion massique en particules diffusantes distincte et de préférence inférieure à une proportion massique des particules diffusantes dans la couche photosensible, de préférence strictement inférieure à une proportion massique des particules diffusantes dans la couche photosensible.

L'introduction de particules diffusantes dans la solution comprenant des modules de conversion de couleur, permet la diffusion du rayonnement lumineux émis par la diode électroluminescente et du rayonnement lumineux réémis par les modules de conversion de couleur, ce qui améliore la conversion de la longueur d'onde et l'extraction du rayonnement lumineux des cavités.

Selon un exemple, l'au moins un motif de l'empilement présente une profondeur comprise entre 5 µm et 30 µm.

Dans le cas où le motif correspond à une cavité, la profondeur de la cavité détermine la quantité de modules de conversion de couleur qui peut être introduite dans la cavité. Cela permet l'optimisation de la conversion de la longueur d'onde par les modules de conversion de couleur et de l'extraction du rayonnement réémis par les modules de conversion de couleur ou du rayonnement émis par les diodes électroluminescentes.

La profondeur de la cavité dépend de la dose d'insolation et de la distance entre le masque et la surface exposée de la couche photosensible.

Selon un exemple, l'au moins un motif de l'empilement est au moins une cavité délimitée au moins en partie par la paroi latérale incurvée.

Selon un exemple, l'au moins un motif du dispositif optoélectronique comprenant l'empilement, est de préférence au moins une cavité délimitée au moins en partie par la paroi latérale incurvée, et au moins une diode électroluminescente disposée dans l'au moins une cavité, la cavité étant configurée de sorte à exposer au moins en partie la diode électroluminescente.

Selon un exemple, le dispositif optoélectronique comprend une solution dans l'au moins une cavité, la solution comprenant des modules de conversion de couleur.

Selon un exemple, le dispositif optoélectronique comprend une solution dans l'au moins une cavité, la solution comprenant des modules de conversion de couleur avec des particules diffusantes, la solution comprenant des modules de conversion de couleur présentant une proportion massique en particules diffusantes inférieure à une proportion massique des particules diffusantes dans la couche photosensible.

L'intégration au dispositif optoélectronique des cavités comprenant une solution comprenant des modules de conversion de couleur avec des particules diffusantes, permet :
- L'amélioration de l'efficacité d'extraction du rayonnement lumineux émis par les photodiodes luminescentes ou réémis par les modules de conversion de couleur, en ajustant la profondeur et la pente des parois latérales incurvées de la cavité,
- L'amélioration de l'efficacité de la conversion de la longueur d'onde par les modules de conversion de couleur en ajustant la profondeur et la pente des parois latérales incurvées de la cavité,
- La limitation de la diaphonie optique entre deux cavités, la diaphonie optique étant la contamination d'une longueur d'onde réémise par les modules de conversion de couleur au sein d'une cavité par la longueur d'onde émise par la diode électroluminescente au sein de la cavité voisine. Cette diaphonie est possible pour toute longueur d'onde. A titre d'exemple, une émission d'un premier rayonnement bleu dans une cavité peut contaminer une émission d'un deuxième rayonnement rouge ou vert dans une cavité voisine. Selon un autre exemple, une émission d'un premier rayonnement vert dans une cavité peut également contaminer une émission d'un deuxième rayonnement rouge ou bleu dans une cavité voisine. Selon un autre exemple, une émission d'un premier rayonnement rouge dans une cavité peut également contaminer une émission d'un deuxième rayonnement vert ou bleu dans une cavité voisine. La contamination par un rayonnement bleu peut notamment être due à une fuite du rayonnement bleu. La contamination par un rayonnement vert ou rouge peut être le résultat d'une fuite du rayonnement vert ou rouge, ou d'une contamination chimique au sein de la cavité,
- L'amélioration de l'émission du rayonnement en champ lointain des diodes électroluminescentes.
- L'amélioration du contraste entre l'émission de deux diodes électroluminescentes voisines.

Selon un exemple, le dispositif optoélectronique comprend au moins trois diodes électroluminescentes configurées pour émettre un rayonnement lumineux présentant une première longueur d'onde, par exemple dans le bleu, et disposées de sorte que :
- une première diode électroluminescente est disposée dans une première cavité comprenant une première solution, la première solution comprenant des premiers modules de conversion de couleur et des particules diffusantes, les premiers modules de conversion de couleur étant configurés pour convertir la première longueur d'onde du rayonnement lumineux émis par la première diode électroluminescente en une deuxième longueur d'onde différente de la première longueur d'onde, de préférence la deuxième longueur d'onde est dans le rouge,
- une deuxième diode électroluminescente est disposée dans une deuxième cavité comprenant une deuxième solution, la deuxième solution comprenant des deuxièmes modules de conversion de couleur et des particules diffusantes, les deuxièmes modules de conversion de couleur étant configurés pour convertir la première longueur d'onde du rayonnement lumineux émis par la deuxième diode électroluminescente en une troisième longueur d'onde différente des première et deuxième longueurs d'onde, de préférence la troisième longueur d'onde est dans le vert,
- une troisième diode électroluminescente est disposée dans une troisième cavité et émettant à la première longueur d'onde, la troisième cavité comprenant une troisième solution, la troisième solution comprenant des particules diffusantes.

Selon un exemple, les premières longueurs d'onde émises par les diodes électroluminescente sont sensiblement égales entre elles. On peut prévoir que ces longueurs d'onde émises par les diodes électroluminescentes soient distinctes entre elles.

Selon un exemple, la troisième solution est exempte de modules de conversion de couleur comprenant des particules diffusantes.

Selon un exemple, l'empilement du dispositif optoélectronique comprend en outre une première couche opaque aux longueurs d'ondes du visible, recouvrant au moins en partie, et de préférence entièrement, la surface exposée de la couche photosensible.

Selon un exemple, la première couche opaque peut être configurée de sorte à séparer les cavités entre elles.

Selon un exemple, le dispositif optoélectronique comprend en outre une deuxième couche opaque à la première longueur d'onde, par exemple dans le bleu du rayonnement lumineux émis par les diodes électroluminescentes, disposée au-dessus des première et deuxième cavités, de sorte à laisser passer les deuxième et troisième longueurs d'ondes converties par les modules de conversion de couleur et à bloquer la première longueur d'onde dans le bleu du rayonnement lumineux émis par les diodes électroluminescentes.

On entend par « dispositif optoélectronique » un dispositif apte à émettre, véhiculer, ou recevoir de la lumière. Selon une application particulière, un tel dispositif optoélectronique comprend des diodes électroluminescentes (LED, de l'anglais « *Light Emitting Diode* »), en particulier des LEDs formant les sous-pixels d'un pixel d'écran émissif.

L'invention peut être mise en oeuvre plus largement pour différents dispositifs optoélectroniques. L'invention peut par exemple être mise en oeuvre dans le cadre de dispositifs laser ou photovoltaïque.

Les LEDs ou dispositifs optoélectroniques présentent typiquement dans le cadre de la présente invention des dimensions, en projection dans un plan de base xy, inférieures à 100 µm*100 µm, de préférence inférieures à 10 µm*10 µm.

Sauf mention explicite, il est précisé que, dans le cadre de la présente invention, la disposition relative d'une deuxième couche intercalée entre une première couche et une troisième couche, ne signifie pas obligatoirement que les couches sont directement au contact les unes des autres, mais signifie que la deuxième couche est soit directement au contact des première et troisième couches, soit séparée de celles-ci par au moins une autre couche ou au moins un autre élément. Ainsi, les termes et locutions « prendre appui », « surmonter », « couvrir » ou « recouvrir » ne signifient pas nécessairement « au contact de ».

Les étapes du procédé s'entendent au sens large de la réalisation d'une partie du procédé et peuvent éventuellement être réalisées en plusieurs sous-étapes. Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Dans la présente demande de brevet, les termes « diode électroluminescente », « LED » ou simplement « diode » sont employés en synonymes. Une « LED » peut également s'entendre d'une « micro-LED » ou d'une « smart LED ».

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une diode à base de GaN comprend typiquement du GaN et des alliages d'AlGaN ou d'InGaN.

Dans le cadre de la présente invention, on qualifie de façon classique de résine un matériau organique ou organo-minéral pouvant être mis en forme par une exposition à un faisceau d'électrons, de photons ou de rayons X ou mécaniquement.

On peut citer à titre d'exemple des résines classiquement employées en microélectronique, des résines à base de polystyrène (PS), de méthacrylate (par exemple le Polymethyl méthacrylate PMMA), d'Hydrosilsesquioxane (HSQ), de polyhydroxystyrène (PHS) etc. L'intérêt d'utiliser une résine est qu'il est facile d'en déposer une épaisseur importante, de plusieurs centaines de nanomètres à plusieurs microns.

Des couches et/ou des revêtements antireflets peuvent être associés aux résines. Cela permet notamment d'améliorer la résolution de lithographie. Dans la suite, les différents masques à base de résine sont de préférence associés à de telles couches antireflets.

Dans le cadre de la présente invention, un objet ou un matériau « transparent » signifie que l'objet ou le matériau laisse passer au moins 90% de l'intensité lumineuse du faisceau lumineux qui le traverse. A contrario, un matériau ou une surface est considérée comme « opaque » dès lors qu'elle absorbe ou stoppe au moins 85% de l'intensité d'un faisceau lumineux incident.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Il est précisé que dans le cadre de la présente invention, l'épaisseur d'une couche ou du substrat se mesure selon une direction perpendiculaire à la surface selon laquelle cette couche ou ce substrat présente son extension maximale. L'épaisseur est ainsi prise selon une direction perpendiculaire aux faces principales de la couche ou du substrat sur lequel repose les différentes couches. Plus particulièrement, l'épaisseur peut être prise selon la direction z.

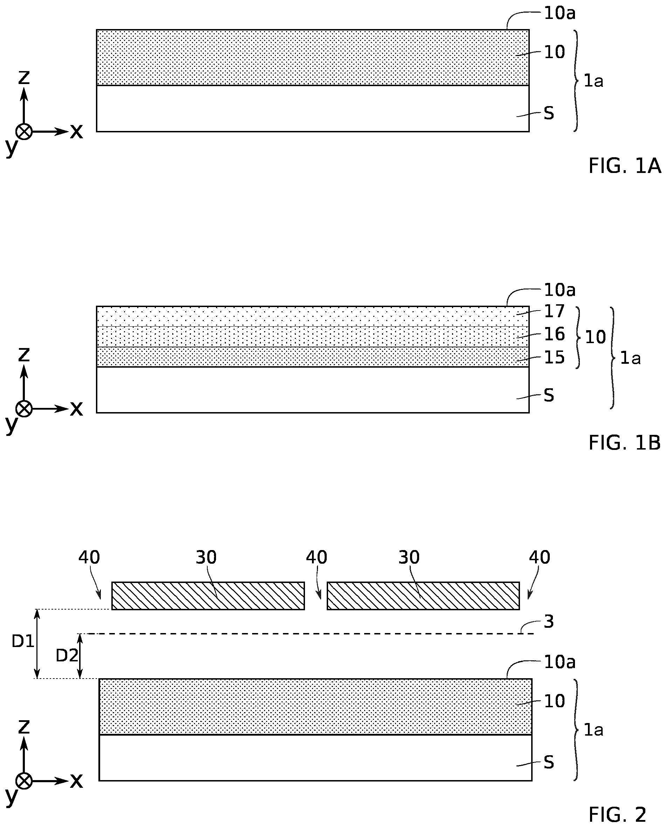

Le procédé de fabrication d'un empilement 1 comprenant au moins un motif 20, 20' à paroi incurvée par lithographie défocalisée est maintenant décrit en référence au figures 1A, 1B, 2, 3, 4A, 4B, 5A à 5D, 6A et 6B, selon des exemples particuliers de réalisation. Dans la suite, on considère à titre non limitatif que plusieurs motifs, cavités ou plots, sont formés.

Comme illustré en figure 1A, le procédé comprend la fourniture d'un ensemble multicouche 1a comprenant un substrat S surmonté d'une couche photosensible 10 présentant une surface exposée 10a. L'ensemble multicouche1a s'étend selon un plan xy défini par une direction x et une direction y perpendiculaire à la direction x.

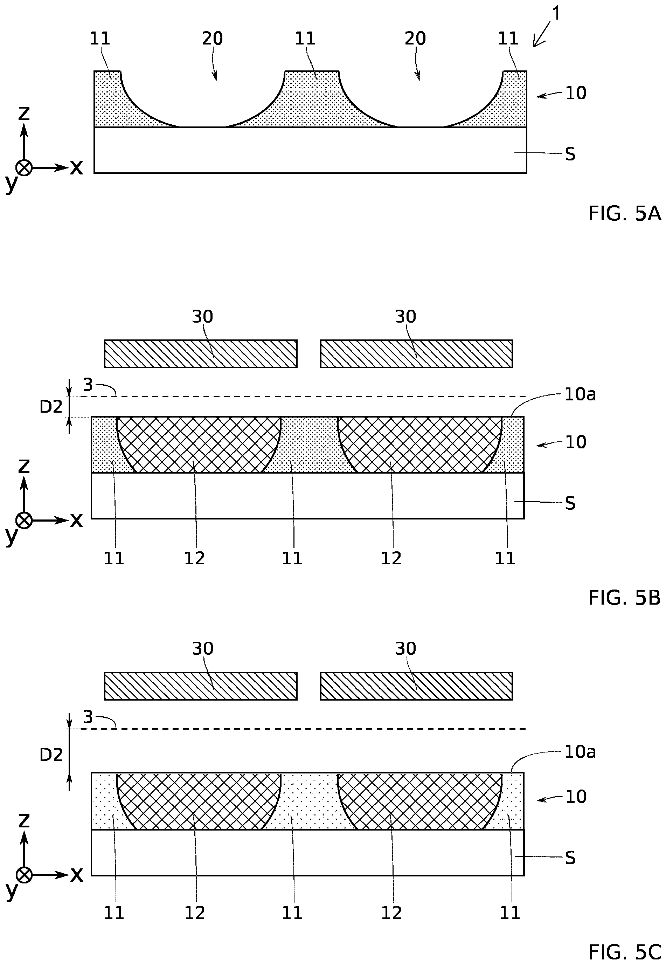

La couche photosensible 10 est à base d'une résine photosensible, dont les propriétés chimiques sont modifiées à l'exposition à un rayonnement lumineux incident 2 (non illustré sur cette figure) à la surface exposée 10a. La couche photosensible 10 comprend des particules aptes à diffuser le rayonnement lumineux incident 2. Ainsi, le rayonnement lumineux incident 2 est diffusé au moins latéralement, selon au moins une direction incluse dans le plan xy. De plus, ces particules présentent une haute réflectivité, ce qui permet d'obtenir des motifs 20, 20' (illustrés à partir Fig. 5A) à parois réfléchissantes.

Le procédé comprend en outre, la fourniture d'un masque 30 comprenant des régions opaques au rayonnement lumineux incident 2, et des régions 40 configurées pour laisser passer le rayonnement lumineux incident 2. Selon un exemple, les régions opaques peuvent être par exemple en forme de plots opaques, par exemple distincts les uns des autres, entourés par une ou des régions 40 transparentes, comme par exemple illustré par les figures 2 à 5C. Selon un exemple alternatif, et décrit plus en détail ultérieurement, le masque 30 peut comprendre au moins une région opaque dans laquelle des régions 40 transparentes, et plus particulièrement des ouvertures, laissent passer le rayonnement lumineux. La forme des régions 40 transparentes du masque 30 est généralement transposée à la couche photosensible 10 à base de résine. D'autres paramètres rentrent en jeu dans la définition de la forme géométrique et les dimensions des motifs résultants. Ces paramètres seront décrits au fur et à mesure dans la description qui suit.

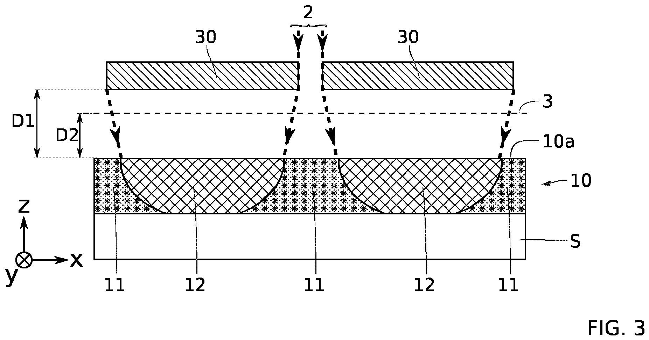

Comme illustré en figure 2, le masque 30 et l'ensemble multicouche 1a sont placés de façon à les espacer d'une distance D1. Cette distance D1 est configurée de sorte que la surface exposée 10a de la couche photosensible 10 ne soit pas disposée dans un plan de focalisation 3 du rayonnement lumineux incident 2. Autrement dit, la distance D1 est configurée afin d'obtenir un faisceau du rayonnement lumineux 2 qui diverge au-delà du plan de focalisation 3, comme illustré en figure 3, suite à sa transmission à travers les régions 40. Cet emplacement permet d'obtenir une image défocalisée de la surface exposée 10a, d'où le terme « lithographie défocalisée ».

Le masque 30 et l'ensemble multicouche 1a étant séparés par la distance D1, le procédé comprend ensuite une insolation des parties de la couche photosensible exposées aux régions 40 transparentes par le rayonnement lumineux incident 2. A son incidence à la surface exposée 10a, le rayonnement lumineux incident 2 est diffusé par les particules dites « diffusantes » présentes dans la couche photosensible 10. Cette diffusion se fait dans tous les sens d'une façon homogène et continue, de sorte à former un gradient de diffusion dont la section dans un plan sensiblement perpendiculaire à la direction z de propagation du faisceau lumineux, par exemple dans un plan parallèle au plan xy, augmente au fur et à mesure de sa pénétration dans la couche photosensible 10, le long de la direction z sensiblement perpendiculaire aux directions x et y.

La divergence du rayonnement lumineux incident 2, en synergie avec la diffusion latérale du rayonnement lumineux incident 2 par les particules diffusantes, permet la formation d'une pluralité de régions insolées 11 délimitées au moins en partie par une paroi latérale incurvée, et une pluralité de régions non-insolées 12 séparées par les régions insolées 11. Une intersection de cette paroi latérale incurvée avec un plan sensiblement perpendiculaire au plan xy, forme des lignes courbes.

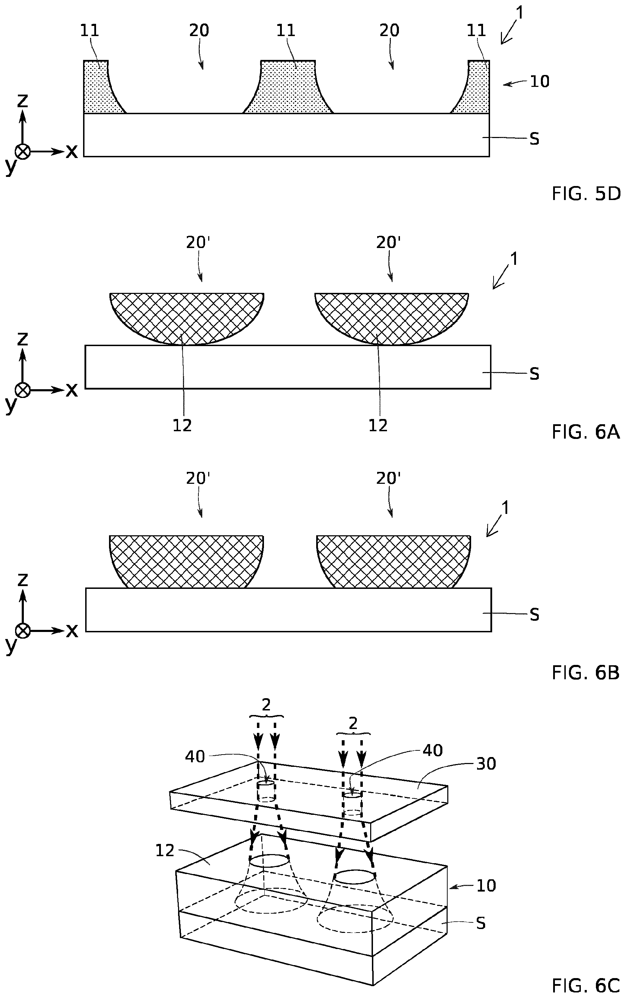

Comme illustré en figures 5A et 6A, le procédé comprend ensuite la formation de motifs 20, 20' à parois incurvées par retrait des régions insolées 11, ou des régions non-insolées 12, respectivement lors d'une étape de développement, comme explicité par la suite.

Selon une première variante, dans le cas d'une couche photosensible 10 à base d'une résine négative, l'insolation par le rayonnement lumineux incident 2, permet la réticulation de la résine dans les régions insolées 11. Les régions non-insolées 12 étant solubles, elles sont ensuite retirées par un solvant spécifique, formant ainsi des cavités 20 creuses à parois latérales incurvées comme le montre la figure 5A.

Selon une deuxième variante, dans le cas d'une couche photosensible 10 à base d'une résine positive insoluble dans son état initial, l'insolation par le rayonnement lumineux incident 2 à travers le même masque illustré dans les figures précédentes, permet de rendre les régions insolées solubles dans un solvant spécifique. Les régions insolées 11 sont ensuite retirées, formant des plots 20' à parois incurvées comme le montre la figure 6A. Notons qu'il est possible de former ensuite une ou des cavités par une étape de moulage d'une couche additionnelle à partir de la couche photosensible 10. Par exemple, une couche peut être déposée sur l'empilement 1 présentant les plots 20' par moulage. La couche ainsi moulée présentera donc des cavités complémentaires aux motifs formés par les plots 20'. Cette couche peut ensuite par exemple être reportée sur un substrat S pour former un empilement 1 comprenant les cavités.

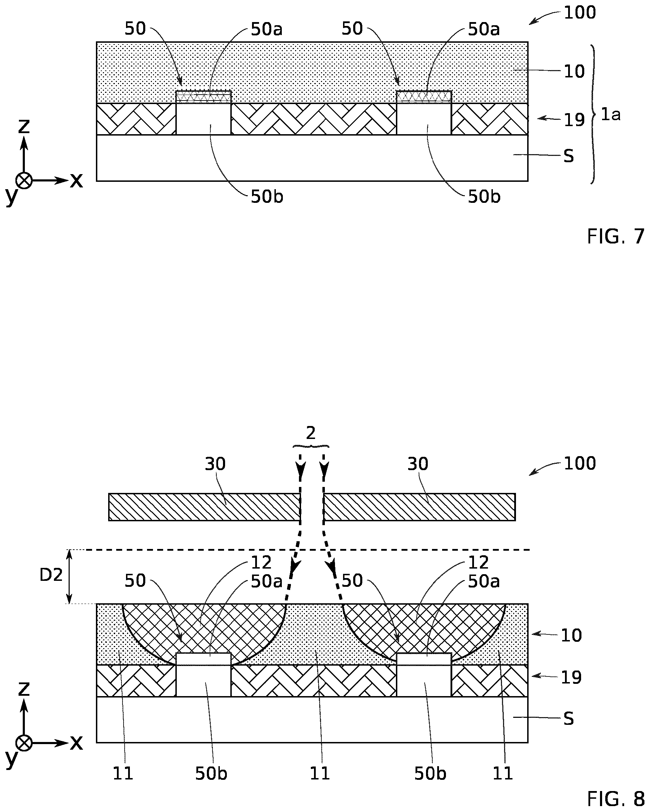

Le substrat S de l'empilement 1 obtenu dépend de l'application du procédé de la présente invention. Le substrat peut être par exemple à base de verre, de polyamide. Le substrat peut aussi être une carte de circuit imprimé FR4 (PCB FR4, ou « Flame Retardant » en anglais). Dans le cas d'un dispositif optoélectronique 100 par exemple illustré sur la figure 8, le substrat S peut être à base de matériaux fonctionnels tels que le saphir, le « TFT » (« Thin-Film transistor », en anglais ou transistor en couche mince), un semiconducteur à oxyde de métal complémentaire (technologie CMOS, ou « Complementary Metal-Oxide-Semiconductor » en anglais), ou le silicium. Le substrat S peut également correspondre à une structure de support à l'affichage, connue sous « Backplane » en terminologie anglo-saxonne. Cette structure peut comprendre des pistes conductrices, des connecteurs, et d'autres éléments conçus pour connecter des diodes électroluminescentes par exemple.

La couche photosensible 10 est à base d'une résine photosensible au rayonnement lumineux incident 2. Cette résine photosensible est configurée pour absorber une longueur d'onde du rayonnement lumineux incident, de préférence une longueur d'onde dans l'ultraviolet (UV). Elle peut être transparente à la lumière visible ou de couleur blanche. La couche photosensible 10 est fabriquée sur le substrat S, de manière générale, par dépôt par enduction centrifuge (ou « spin-coating » selon la terminologie usuelle anglo-saxonne).

L'épaisseur de la couche photosensible est adaptée en fonction de la profondeur des motifs résultants et de l'application du procédé souhaitées. Elle est typiquement comprise entre 5 µm et 100 µm, de préférence égale à 20 µm pour un dispositif optoélectronique 100.

Suite à son dépôt, la couche photosensible 10 peut avantageusement subir un premier traitement thermique de recuit dit « doux » (« soft-bake » en anglais), qui permet d'améliorer sa stabilité. Ce premier traitement thermique de recuit est mis en oeuvre, de préférence, à 110°C, par exemple pendant une durée de 2 min.

Les particules diffusantes présentes dans la couche photosensible 10, sont configurées pour diffuser le rayonnement lumineux incident 2. L'amélioration de la diffusion du rayonnement lumineux incident permet notamment l'extension latérale de la région insolée dans le plan xy. La diffusion de ces particules dépend notamment de leur nature, de la taille des particules, ainsi que de leur charge dans la couche photosensible, ou de leur proportion massique par rapport à la masse totale de la couche photosensible 10.

Afin d'améliorer la diffusion du rayonnement lumineux incident 2, la taille des particules peut être adaptée. De préférence, la taille de ces particules, par exemple le diamètre moyen, est choisi de même ordre que la longueur d'onde du rayonnement lumineux incident 2. La longueur d'onde du rayonnement lumineux incident 2 peut être choisie dans le visible ou dans le proche infrarouge. Le choix de la longueur d'onde peut potentiellement impacter la résolution de la lithographie. La longueur d'onde du rayonnement lumineux incident 2 est typiquement choisie dans la gamme spectrale de l'UV qui correspond aux équipements existants et standards en micro-électronique. Elle peut être égale à 365 nm (« I-line » en anglais), 248 nm ou 193 nm (ultraviolet profond, « DUV » ou « Deep Ultraviolet » en anglais). En se basant sur cette gamme spectrale, le diamètre moyen des particules diffusantes peut être choisi entre 100 nm et 1000 nm, de préférence entre 100 nm et 500 nm, de préférence entre 150 nm et 300 nm.

Les particules diffusantes présentes dans la couche photosensible 10, sont en outre configurées pour améliorer la réflectivité des surfaces des motifs résultants. La réflectivité des particules diffusantes dépend du type de matériau choisi, la taille des particules ainsi que leur proportion massique par rapport à la masse totale de la couche photosensible 10. Par exemple, le choix d'un matériau comprenant au moins un métal, permet d'améliorer la réflectivité des particules diffusantes. Selon le matériau choisi et la charge des particules dans la couche photosensible 10, les particules diffusantes présentent une réflectivité comprise entre 20% et 100%, de préférence entre 75% et 100%.

Les particules diffusantes sont choisies parmi le groupe constitué de : des oxydes de métaux de formule MₓO_{y}, avec x, y des entiers positifs non nuls, tels que le dioxyde de titane (TiO₂), l'oxyde de zinc (ZnO), l'oxyde de manganèse (MnO), les oxydes de lanthanides (Ln₂O₃), l'oxyde d'aluminium (Al₂O₃), l'oxyde de magnésium (MgO), l'oxyde de silicium (SiOz), les oxydes de fer (FeₓO_{y}), l'oxyde de zirconium (ZrOz), et des nanoparticules à base d'au moins un métal tel que l'argent (Ag), l'or (Au), le platine (Pt), le nickel (Ni), l'aluminium (AI) ou le chrome (Cr).

La proportion massique des particules diffusantes dans la couche photosensible 10 représente le rapport de la masse totale des particules diffusantes à la masse totale de la couche photosensible 10 à l'état solide. Cette proportion massique est un paramètre particulièrement avantageux pour contrôler la pente ou la courbure des parois des motifs. Plus la résine photosensible est chargée en particules diffusantes, plus le rayonnement lumineux incident 2 est diffusé latéralement selon le plan xy dans la couche photosensible, ce qui résulte en une faible pente de la paroi. De plus, l'augmentation de la proportion massique des particules diffusantes dans le couche photosensible 10, permet l'amélioration de la réflectivité des parois des motifs résultants. La résine photosensible présente une proportion massique de particules diffusantes comprise entre 1% et 40%, de préférence entre 3% et 20%.

Selon une variante de la présente invention, la couche photosensible 10 peut comprendre plusieurs sous-couches 15, 16, 17, superposées suivant la direction z, comme illustré en figure 1B.

Chaque sous-couche 15, 16, 17, présente une proportion massique en particules diffusantes distincte entre les plusieurs sous-couches 15, 16, 17. Cette proportion massique peut varier d'une sous-couche à l'autre. La variation de la proportion massique représente un paramètre additionnel qui permet de moduler la courbure ou la pente des parois incurvées des motifs résultants.

Selon une variante de la présente invention, les sous-couches 15, 16, 17, sont à base d'une résine négative, et la proportion massique des particules diffusantes augmente entre deux sous-couches successives en s'éloignant de la surface exposée 10a.

Selon une autre variante de la présente invention, les sous-couches 15, 16, 17, sont à base d'une résine positive, et la proportion massique des particules diffusantes peut diminuer ou augmenter entre deux sous-couches successives en s'éloignant de la surface exposée 10a, selon la courbure de parois souhaitée. La variation, d'une sous-couche à l'autre, de la proportion massique des particules diffusantes, à base de TiOz par exemple, peut être inférieure ou égale à 30 % par exemple. Cette variation peut être de l'ordre de 3%, 6%, 9% et 12% par exemple. Des changements de valeurs de diffusion significatifs ont été mesurés pour ces valeurs. D'autres valeurs de variation de la proportion massique d'une sous-couche à l'autre peuvent toutefois être envisagées.

La géométrie des régions insolées 11 et des régions non-insolées 12 qui définiront la géométrie des motifs 20, 20' après développement selon le type (négatif ou positif) de la résine photosensible, peut être contrôlée par plusieurs paramètres tels que la dose d'insolation par le rayonnement lumineux incident 2, l'emplacement du masque par rapport à la surface exposée 10a et la proportion massique des particules diffusantes dans la couche photosensible 10.

La dose d'insolation détermine la quantité d'énergie absorbée par la résine photosensible lors de l'exposition au rayonnement lumineux incident 2. Cette dose d'insolation permet de contrôler la profondeur de la région insolée 11, et par conséquent, la profondeur du motif 20, 20' obtenu après développement. De plus, la dose d'insolation permet de contrôler les dimensions externes de la région insolée 11, autrement dit, les dimensions latérales de la région insolée 11 dans le plan de la surface exposée 10a, typiquement parallèle au plan xy. En contrôlant les dimensions externes de la région insolée 11, la distance qui sépare deux motifs 20, 20' juxtaposés est aussi contrôlée. En augmentant la dose d'insolation, la profondeur du motif 20, 20' augmente et la distance séparant deux motifs 20, 20' voisines diminue. La dose d'insolation est typiquement comprise entre 50 mJ/cm² et 3000 mJ/cm².

Selon un exemple, le masque 30 est disposé de façon parallèle à la surface exposée 10a. Le masque 30 est notamment placé par rapport à la surface exposée 10a de sorte que la distance D1 soit strictement supérieure à une distance entre le masque 30 et le plan de focalisation 3. Cette distance entre le masque 30 et le plan de focalisation 3 est choisie de sorte que la surface exposée 10a soit écartée du plan de focalisation 3 d'une distance D2. La variation de la distance D2 permet de contrôler la pente de la paroi latérale incurvée délimitant la région insolée 11 et la région non-insolée 12. Quand le rayonnement lumineux incident 2 est focalisé sur la surface exposée 10a de la couche photosensible 10, c'est-à-dire quand la distance D2 est nulle, et en absence de particules diffusantes dans la couche photosensible, les parois latérales de la région insolée 11 ou de la région non-insolée 12 sont tranchantes et droites. Plus la position de la surface exposée 10a de la couche photosensible 10 s'éloigne du plan de focalisation 3, c'est-à-dire plus la distance D2 augmente, le rayonnement lumineux incident 2 diverge de plus en plus en pénétrant la couche photosensible 10, et par conséquent, la pente des parois latérales de la région insolée 11 ou de la région non-insolée 12 diminue. La distance D2 peut être comprise entre 100 nm et 100 µm, de préférence entre 10 µm et 100 µm.

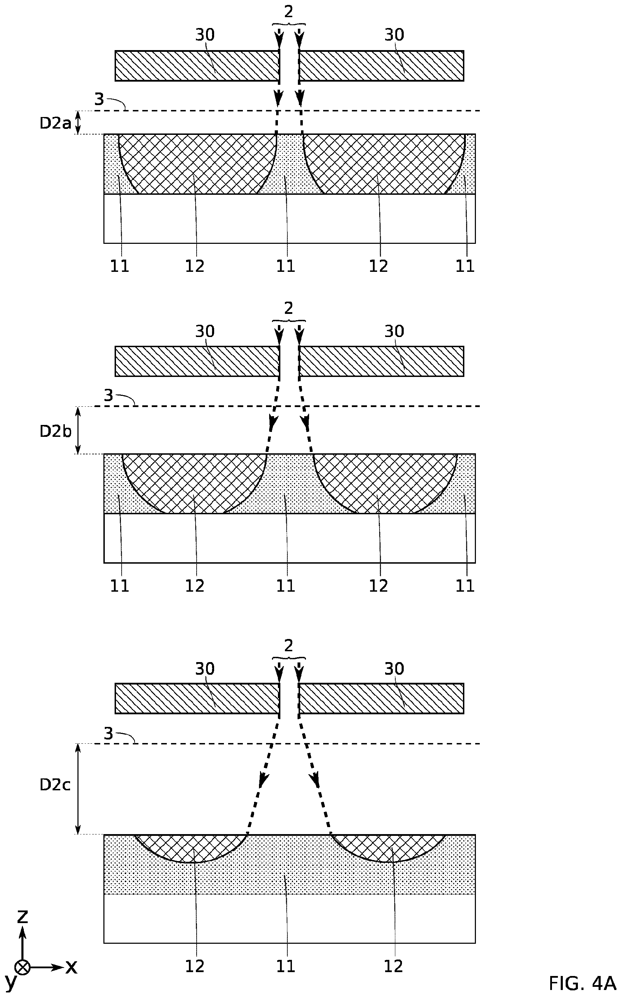

La figure 4A illustre différents emplacements du masque par rapport à la surface exposée 10a, pour trois distances différentes D2a<D2b<D2c, et pour une proportion massique de particules diffusantes fixe, ici dans le cas d'une résine négative Pour une distance D2a faible, les parois latérales de la région non-insolée 12 ont une pente importante, et la profondeur de la région non-insolée 12 s'étend jusqu'à la face inférieure de la couche photosensible 10, formant ainsi une paroi transversale droite séparant les parois latérales incurvées. Pour une distance intermédiaire D2b, les parois latérales de la région non-insolée 12 présentent une pente intermédiaire plus faible et se rapprochent l'une de l'autre, et la profondeur de la région non-insolée 12 s'étend jusqu'à la face inférieure de la couche photosensible 10. Pour une grande distance D2c, les parois latérales de la région non-insolée 12 présentent une pente encore plus faible, et se rejoignent pour former une paroi incurvée continue dans la couche photosensible 10, sans que la profondeur de la région non-insolée 12 atteigne la face inférieure de la couche photosensible 10. La distance D2 permet ainsi de contrôler en outre les dimensions internes de la région non-insolée 12, c'est-à-dire les dimensions transversales à la profondeur la région non-insolée 12, dans un plan parallèle au plan xy et inférieur au plan comprenant la surface exposée 10a.

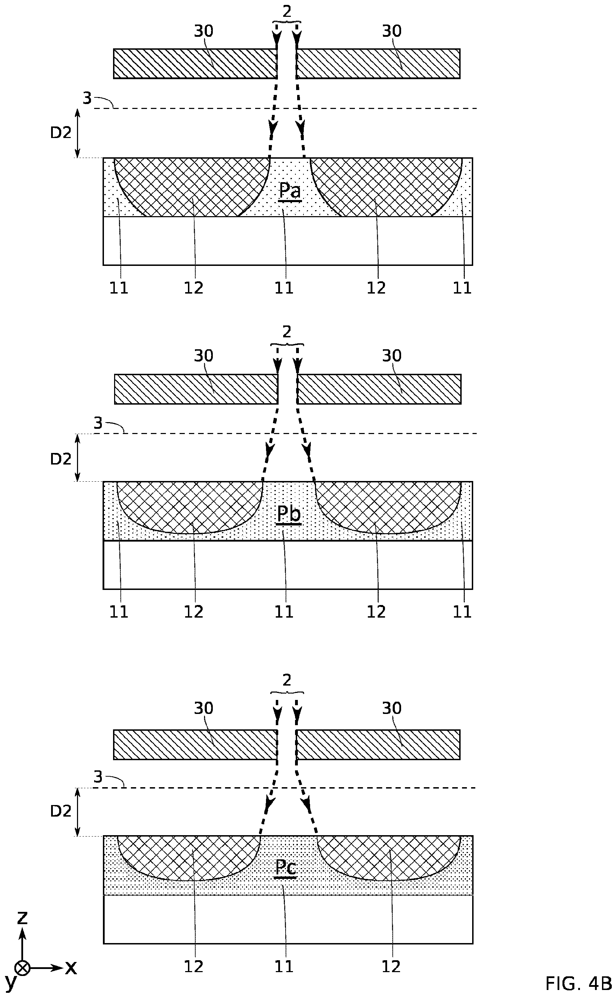

La proportion massique des particules diffusantes présentes dans la couche photosensible 10, permet également de contrôler les dimensions internes de la région non-insolée 12 ainsi que la courbure des parois incurvées. En effet, plus la résine, ici négative, est chargée en particules diffusantes, plus le rayonnement est diffusé latéralement dans la couche photosensible 10, ce qui résulte en une faible courbure de la paroi. La figure 4B illustre trois proportions massiques de particules diffusantes distinctes, Pa<Pb<Pc, pour une distance D2 fixe. Comme la figure 4B le montre, plus la couche photosensible est chargée en particules diffusantes, plus la courbure de la paroi incurvée est importante.

La figure 5A, illustre la géométrie de la cavité 20 à parois latérales incurvées, obtenue pour une résine négative après le retrait de la région non-insolée 12. Une intersection de ces parois avec un plan sensiblement perpendiculaire au plan xy, forme des lignes courbes. Les rayons de courbure de ces lignes courbes s'étendent au moins en partie dans la cavité 20. En outre, une section transversale de la cavité 20 prise selon un plan dans la couche photosensible 10 parallèle au plan xy, présente une aire variable selon la direction z. De préférence, cette aire décroît en s'éloignant de la surface exposée 10a, et de préférence sur toute la hauteur de la cavité 20. Notons qu'on peut prévoir que, pour une portion desdites lignes courbes, ces lignes courbes présentent un ou des rayons de courbure s'étendent dans la couche photosensible 10.

Pour une première distance D2 et une première proportion massique de particules diffusantes, cette cavité 20 présente des parois ayant une première pente, une première courbure et des premières dimensions internes. Comme décrit précédemment, ces paramètres peuvent être contrôlées, soit en fixant la première proportion massique des particules diffusantes et en diminuant D2, comme illustré en figure 5B, soit en fixant la première distance D2 et en diminuant la proportion massique des particules diffusantes, comme illustré en figure 5C. La géométrie de la cavité 20 obtenue pour ces deux cas est illustrée en figure 5D. La géométrie peut ainsi être contrôlée en fonction de l'application souhaitée. Pour un dispositif optoélectronique 100, la géométrie illustrée en figure 5A est plus avantageuse, comme cela sera décrit ultérieurement.

La figure 6A illustre la géométrie du plot 20' à parois latérales incurvées, obtenu pour une résine positive après le retrait de la région insolée 11. Une intersection de ces parois avec un plan sensiblement perpendiculaire au plan xy, forme des lignes courbes. Les rayons de courbure de ces lignes courbes s'étendent au moins en partie dans la région non-insolée 12. Notons qu'on peut prévoir que, pour une portion desdites lignes courbes, ces lignes courbes présentent un ou des rayons de courbure s'étendant dans l'espace séparant les plots 20'. En outre, une section transversale du plot 20' prise selon un plan dans la couche photosensible 10 parallèle au plan xy, présente une aire variable selon la direction z. De préférence, cette aire décroît en s'éloignant de la surface exposée 10a vers le substrat 10, et plus préférentiellement sur toute la hauteur du plot 20'. La géométrie du plot 20' illustré en figure 6A, obtenu pour une première distance D2 et une première proportion massique de particules diffusantes, est peu stable et risque de s'effondrer après le développement. Pour améliorer la stabilité de cette géométrie, les mêmes paramètres, par analogie aux figures 5B et 5C peuvent être variés. La figure 6B illustre la géométrie plus stable des plots 20' obtenue après le développement, en variant ces paramètres.

Selon un exemple différent illustré en figure 6C, des cavités ponctuelles peuvent être obtenues dans une couche de résine positive avec une autre configuration de masque 30, présentant une région opaque dans laquelle des régions 40 transparentes, ici sous forme d'ouvertures, laissent passer le rayonnement lumineux. Ces cavités présentent une paroi incurvée dite « déversante », qui contrairement à la cavité obtenue dans une résine négative, présente un rayon de courbure qui ne s'étend pas au sein de la cavité mais dans la région non-insolée 12. Cette forme n'est toutefois pas optimale pour l'extraction de la lumière hors de la cavité.

Suite à l'étape de développement, la couche photosensible 10 peut avantageusement subir un deuxième traitement thermique de recuit « fort » (« hard-bake » en anglais), qui permet d'améliorer la stabilité des motifs 20, 20'. Ce deuxième traitement thermique de recuit et mis en oeuvre, de préférence, à 180°C pendant une durée de 10 min.

Le procédé de lithographie défocalisée décrit ci-dessus, permet la fabrication d'un empilement 1 comprenant des motifs 20, 20' à parois incurvées qui peuvent correspondre soit à des plots 20', soit à des cavités 20. Dans le cadre d'une application en optoélectronique, l'empilement 1 comprenant des cavités 20 fabriquées dans une couche photosensible à base d'une résine négative, peut avantageusement être intégré à un dispositif optoélectronique 100. Ce dispositif optoélectronique 100, comprend des diodes électroluminescentes 50 (« LED » ou *« Light-Emitting Diode »* en anglais) émettant un rayonnement lumineux à une première longueur d'onde, de préférence dans le bleu ou dans l'UV. En configurant les cavités 20 à parois incurvées et réfléchissantes, de sorte que chaque cavité 20 expose au moins en partie une zone active 50a d'une diode électroluminescente 50 distincte, les performances du dispositif optoélectronique 100 peuvent être améliorée, comme par exemple l'extraction du rayonnement émis par les diodes électroluminescentes 50 et l'amélioration de l'émission du rayonnement en champ lointain des diodes électroluminescentes 50.

Les figures 7, 8, 9A, 9B, 10, 11 et 12 illustrent schématiquement les différentes étapes de fabrication du dispositif optoélectronique 100 selon le procédé décrit ci-dessus.

Comme illustré en figure 7, un ensemble multicouche 1a comprend un substrat S surmonté d'une pluralité de diodes électroluminescentes 50. Chaque diode électroluminescente 50 comprend une zone passive 50b surmonté de la zone active 50a. Le substrat S peut alors comprendre une couche de connexion électrique permettant la connexion électrique des diodes 50. Le substrat S peut correspondre à un substrat Backplane par exemple, dans lequel des plots de connexions électriques et pistes électriques sont présents au préalable et permettent le pilotage des diodes électroluminescentes 50.

L'ensemble multicouche 1a peut comprendre en outre une couche préliminaire 19 fabriquée sur le substrat S. La couche préliminaire 19 est notamment configurée de sorte à couvrir des flancs de la zone passive 50b, et à exposer des flancs de la zone active 50a de chaque diode électroluminescente 50. La couche préliminaire 19 peut être déposée sur le substrat S par enduction centrifuge. Elle peut être à base d'une résine transparente à la lumière visible ou de couleur blanche. Afin de stabiliser la couche préliminaire 19, un premier traitement thermique doux, par exemple à 110°C pendant 2 min peut être mis en oeuvre. Ce traitement peut être suivi d'une étape d'insolation à une énergie égale à 950 mJ. L'insolation peut être suivie d'un deuxième traitement thermique fort, par exemple à 180°C pendant 10 min.

La couche photosensible 10 comprenant des particules diffusantes ayant une bonne réflectivité, est ensuite fabriquée sur la couche préliminaire 19, selon le procédé décrit ci-dessus. La couche photosensible 10 est de préférence à base d'une résine négative et couvre des faces supérieures et les flancs des zones actives 50a. On peut prévoir que le dispositif optoélectronique 100 soit fabriqué avec une résine positive, par exemple par le biais de l'étape de moulage décrite précédemment pour former les cavités. Dans la suite, on décrit plus en détail les étapes pour une résine négative.

L'amélioration de la réflectivité de la couche photosensible 10, permet d'obtenir des cavités 20 à parois incurvées réfléchissantes. Ces parois étant incurvées et réfléchissantes, permettent d'améliorer l'extraction du rayonnement lumineux émis par les diodes électroluminescentes 50 par plusieurs réflexions sur les parois dans la cavité 20 jusqu'à leur extraction. La disposition des diodes au sein d'une cavité ayant des parois et un fond présentant un certain degré de réflectivité, permet en outre de se passer d'un dépôt d'une couche métallique servant comme un miroir au fond de la cavité. Cette couche métallique, à base d'aluminium par exemple, peut induire des étapes supplémentaires au procédé de fabrication des parois, comme des étapes de dépôt du métal, de protection des composants tels que les diodes par un masque, et le retrait de ce dernier. De plus, cette couche métallique, qui est généralement déposée sur un substrat, de type Backplane par exemple, ce substrat comprenant au préalable les diodes électroluminescentes, risque de détériorer l'efficacité du dispositif optoélectronique.

Comme illustré en figure 8, les régions insolées 11 et les régions non-insolées 12 sont par exemple formées lors de l'exposition de la couche photosensible 10 au rayonnement lumineux incident 2 à travers les régions 40 transparentes dans le masque 30. L'emplacement des régions 40 transparentes est configuré de sorte à former une région non-insolée 12 au-dessus de chaque diode électroluminescente 50. Les paramètres contrôlant la pente des parois incurvées et les dimensions des régions non-insolées 12, notamment la distance D2, sont optimisés afin que les parois incurvées de chaque région non-insolée 12 soient raccordées avec une face inférieure de la zone active 50a de la diode électroluminescente 50 correspondante. Cela permet d'améliorer l'extraction du rayonnement lumineux émis par les diodes électroluminescentes 50 au sein des cavités 20.

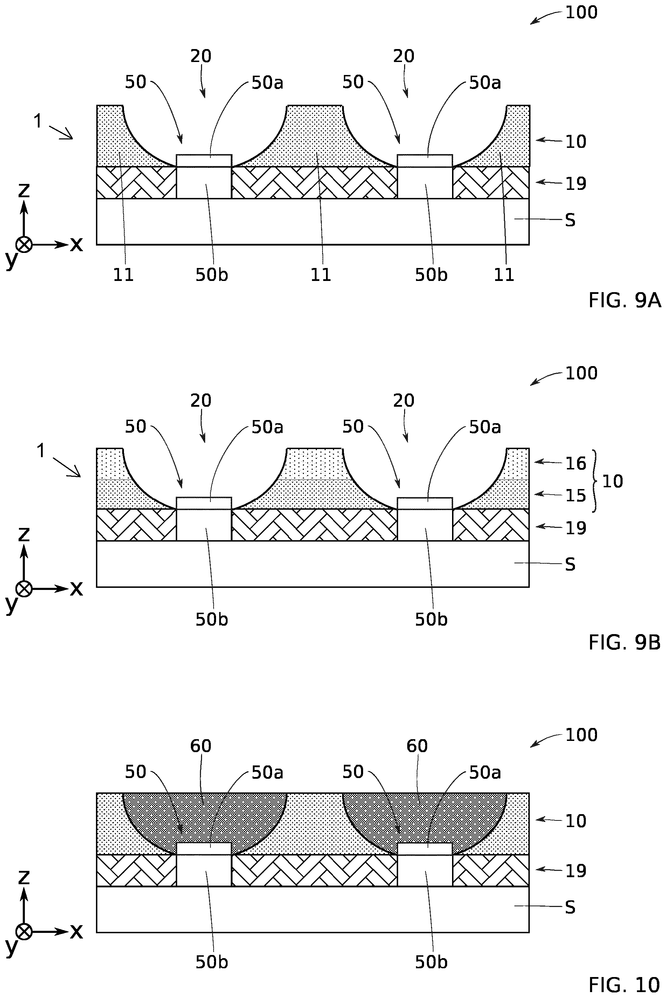

Comme illustré en figure 9A, les régions non-insolées 12 peuvent ensuite être retirées lors d'une étape de développement, formant ainsi les cavités 20, chaque cavité 20 exposant la face supérieure ainsi que les flancs de la zone active 50a de la diode électroluminescente 50 correspondante.

Afin d'optimiser le raccordement entre les parois incurvées des cavités 20 et la face inférieure de la zone active 50a, une sur-gravure des régions non-insolées 12 peut être réalisée. Cette sur-gravure peut retirer jusqu'à 10 µm d'épaisseur de la région non-insolée 12.

Comme illustré en figure 9B, afin de moduler la pente des parois incurvées des cavités 20, selon une variante de la présente invention, la couche photosensible 10 peut comprendre plusieurs sous-couches 15, 16, comme décrit précédemment. Chaque sous-couche 15, 16, peut présenter une proportion massique de particules diffusantes distincte qui augmente entre deux sous-couches successives en s'éloignant de la surface exposée 10a.

Comme illustré en figure 10, après la formation des cavités 20, une solution 60 comprenant des modules de conversion de couleur, est déposée dans les cavités 20. Les modules de conversion de couleur peuvent être sous forme de blocs photoluminescents diffusant, comprenant des luminophores ou des particules d'au moins un matériau photoluminescent, dispersées par exemple dans une matrice transparente (i.e. résine photosensible). Les particules photoluminescentes peuvent se présenter sous la forme de boîtes quantiques (« quantum dots » en anglais), c'est-à-dire sous la forme de nanocristaux semiconducteurs dont le confinement quantique est sensiblement tridimensionnel. L'introduction des modules de conversion de couleur dans les cavités 20 permet la conversion de la première longueur d'onde dans le bleu et/ou UV du rayonnement émis par la diode électroluminescente 50, en absorbant ce rayonnement et en réémettant un rayonnement lumineux à une longueur d'onde différente. Selon un exemple, la première longueur d'onde peut être dans l'UV. Dans ce cas-là, cette première longueur d'onde peut être reconvertie en bleu, en introduisant des modules de conversion de couleur configurés pour absorber le rayonnement UV et réémettre un rayonnement bleu. La longueur d'onde de la lumière réémise par les modules de conversion de couleur dépend de la taille et de la composition des particules photoluminescentes présentes dans les modules de conversion de couleur.

Les paramètres contrôlant la distance qui sépare deux cavités 20 peuvent être optimisés afin de limiter la diaphonie optique et d'améliorer le contraste entre deux diodes électroluminescentes 50 juxtaposées. La diaphonie optique étant la contamination d'une longueur d'onde émise par la diode électroluminescente ou une longueur d'onde réémise par les modules de conversion de couleur au sein d'une cavité au sein de la cavité 20 voisine. La distance qui sépare deux cavités 20 est de préférence comprise entre 10 µm et 100 µm. La solution 60 comprenant des modules de conversion de couleur, peut comprendre en outre des particules diffusantes aptes à diffuser le rayonnement émis par les diodes électroluminescentes 50 et le rayonnement réémis par les modules de conversion de couleur, ce qui améliore d'une part la conversion de la longueur d'onde, et d'autre part, l'extraction du rayonnement réémis par les modules de conversion de couleur.

En alternative, la cavité 20 peut être remplie par une solution exempte de modules de conversion de couleur, comprenant des particules diffusantes. Cela permet d'augmenter la diffusion du rayonnement émis par la diode électroluminescente 50, et par conséquent, d'améliorer l'extraction de ce rayonnement. Certaines cavités 20 peuvent comprendre une solution 60 comprenant des particules diffusantes et des modules de conversion de couleur, et d'autre cavités 20 peuvent comprendre une solution 60 comprenant des particules diffusantes et exempte de modules de conversion de couleur.

La solution 60 présente une proportion massique en particules diffusantes inférieure à la proportion massique des particules diffusantes présentes dans la couche photosensible 10. Ainsi, le couplage entre cavités voisines est diminué. L'extraction du rayonnement lumineux est encore améliorée.

La profondeur de la cavité 20 peut avantageusement être optimisée en fonction de la concentration des modules de conversion de couleur dans la solution 60. La concentration des modules de conversion de couleur dans la solution 60, et notamment en fonction d'une épaisseur de la zone active 50a, influe sur l'efficacité de la conversion de la longueur d'onde. La profondeur de la cavité 20 peut être ajustée selon les paramètres du procédé décrits précédemment, et présente une profondeur typiquement comprise entre 5 µm et 30 µm. Des calculs montrent qu'au-delà d'un seuil de 30 µm, l'effet des parois de la cavité 20 sur l'extraction du rayonnement lumineux émis par les diodes électroluminescentes 50 devient minime, notamment dans le cas d'une extraction d'un rayonnement bleu, en raison de l'absorption de ce rayonnement par les modules de conversion de couleur. Ainsi, plus la concentration des modules de conversion de couleur dans la solution 60 diminue, plus ce seuil augmente. En effet, l'efficacité des parois est diminuée en fonction de sa distance avec les diodes 50. En revanche, cette distance dépend de la concentration de la solution 60 en modules de conversion de couleur. Une raison pour laquelle les parois deviennent moins efficaces est que les modules de conversion de couleur absorbent la lumière bleue de la diode électroluminescente 50. Donc moins les modules de conversion de couleur sont concentrés, plus la distance seuil qui rend les parois peu efficaces est grande. Cependant, dans le cas d'une extraction d'un rayonnement à une longueur d'onde supérieure à celle du bleu, comme celle du vert ou du rouge par exemple, si le module de conversion de couleur est bien configuré pour réémettre un rayonnement à la bonne longueur d'onde, tous les modules émettent cette longueur d'onde. Par conséquent, la réflectivité de la paroi influe significativement sur l'extraction de la lumière, même si les cavités sont assez profondes.

La solution 60 comprenant des modules de conversion de couleur peut remplir la cavité 20 jusqu'à une hauteur h₆₀ (non illustrée) plus petite ou égale à la profondeur de la cavité 20. La hauteur h₆₀ de la solution 60 est notamment configurée de sorte à optimiser l'efficacité de conversion de la longueur d'onde en fonction de la concentration en modules de conversion de couleur ainsi que la proportion massique en particules diffusantes dans la solution 60. La hauteur h₆₀ de la solution 60 peut être typiquement comprise entre 1 µm et 20 µm.

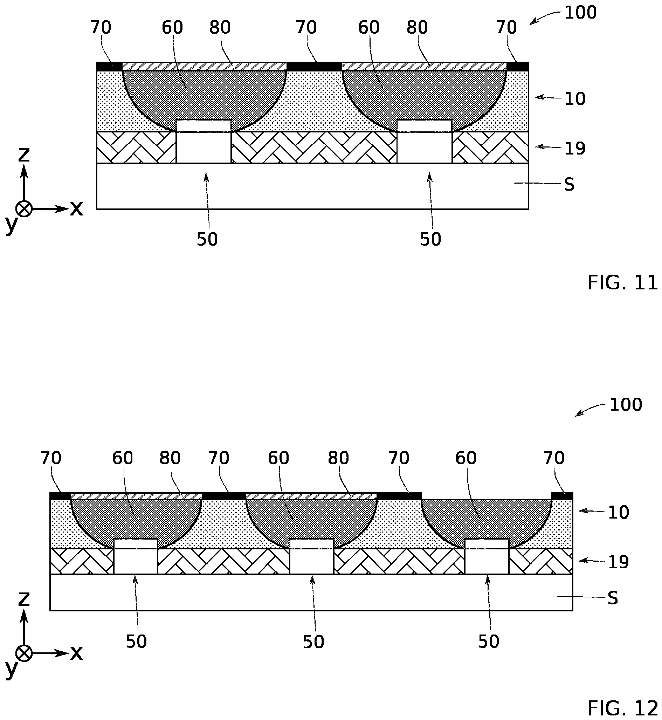

La figure 11 illustre deux exemples optionnels de la présente invention. Une première couche 70 opaque aux longueurs d'ondes du visible peut avantageusement être fabriquée sur la surface exposée 10a de la couche photosensible. Cette première couche 70 opaque permet notamment l'amélioration du contraste entre deux rayonnements lumineux émis de deux cavités 20 juxtaposées. Elle recouvre pour cela au moins en partie, et de préférence entièrement, la surface exposée 10a de la couche photosensible 10. La première couche 70 opaque peut être configurée de sorte à séparer les cavités 20 entre elles. La première couche 70 peux être à base d'une résine. Elle peut être déposée par enduction centrifuge à l'aide d'un masque présentant une configuration permettant la protection des cavités 20 et l'exposition d'au moins en partie, et de préférence entièrement, la surface exposée 10a de la couche photosensible 10. La première couche 70 présente typiquement une épaisseur comprise entre 1 µm et 10 µm, de préférence entre 0,1 µm et 2 µm, selon le contraste souhaité.

Comme illustré en figure 11, une deuxième couche 80 opaque à la première longueur d'onde dans le bleu du rayonnement lumineux émis par les diodes électroluminescentes 50 peut être fabriquée. Cette deuxième couche 80 peut être configurée pour laisser passer les longueurs d'onde réémises par les modules de conversion de couleur et bloquer la première longueur d'onde dans le bleu du rayonnement lumineux émis par les diodes électroluminescentes 50. Pour cela, la deuxième couche 80 peut être disposée au-dessus des cavités 20 comprenant la solution 60 comprenant des modules de conversion de couleur. La deuxième couche 80 présente une épaisseur typiquement comprise entre 0,1 µm et 5 µm.

Selon un exemple, la première couche 70 peut être fabriquée après la formation des cavités 20 et avant l'introduction de la solution 60 dans les cavités. La deuxième couche 80 est ensuite formée suite à l'introduction de la solution 60 dans les cavités. Selon un exemple plus avantageux, la deuxième couche 80, puis la première couche 70 sont fabriquées successivement après la formation des cavités 20 et l'introduction de la solution 60 dans les cavités. La fabrication de la première couche 70 en dernier, permet dans le cadre d'un dispositif d'affichage par exemple, d'améliorer le contraste et d'obtenir un affichage plus net. Une couche additionnelle barrière non illustrée peut être déposée sur la solution 60 comprenant des modules de conversion de couleur. Cette couche barrière sert à protéger les modules de conversion de couleur de l'air et l'humidité ambiante. Cette couche peut être fabriquée par dépôt en couches atomiques (ALD, ou « Atomic Layer Déposition » en anglais). La couche barrière peut être à base de Al₂O₃.

La figure 12 illustre une variante de la présente invention, dans laquelle le dispositif optoélectronique 100 comprend au moins trois cavités 20 distinctes configurées de la façon suivante :
- Une première diode électroluminescente 50 émettant un rayonnement lumineux à une première longueur d'onde est disposée dans une première cavité 20 comprenant une première solution 60. La première solution 60 comprend des premiers modules de conversion de couleur et des particules diffusantes. Les premiers modules de conversion de couleur sont configurés pour convertir la première longueur d'onde, par exemple du bleu, en une deuxième longueur d'onde, de préférence dans le rouge. La deuxième couche 80 est disposée au-dessus de la première cavité 20 comprenant la première solution 60, et laisse passer la deuxième longueur d'onde et bloque la première longueur d'onde.
- Une deuxième diode électroluminescente 50 émettant un rayonnement lumineux à une première longueur d'onde est disposée dans une deuxième cavité 20 comprenant une deuxième solution 60. La deuxième solution 60 comprend des deuxièmes modules de conversion de couleur et des particules diffusantes. Les deuxièmes modules de conversion de couleur sont configurés pour convertir la première longueur d'onde, par exemple du bleu, en une troisième longueur d'onde distincte de la deuxième longueur d'onde, de préférence dans le vert. La deuxième couche 80 est disposée au-dessus de la deuxième cavité 20 comprenant la première solution 60, et laisse passer la troisième longueur d'onde et bloque la première longueur d'onde.
- Une troisième diode électroluminescente 50 émettant un rayonnement lumineux à une première longueur d'onde est disposée dans une troisième cavité 20 comprenant une troisième solution 60. La troisième solution 60 est de préférence exempte de modules de conversion de couleur, et comprend des particules diffusantes. La troisième cavité 20 n'est pas couverte par la deuxième couche 80 afin de laisser passer le rayonnement lumineux à la première longueur d'onde émis par la troisième diode électroluminescente 50.

De préférence, les modules de conversion de couleur sont des boîtes quantiques, c'est à dire sous forme de nanocristaux semiconducteurs dont le confinement quantique est sensiblement tridimensionnel.

Un tel dispositif optoélectronique 100 peut être employé pour former un écran émissif, où chaque cavité 20 comprenant une diode électroluminescente 50 et une solution 60 permettant l'émission d'un rayonnement lumineux à une longueur d'onde différente, forme un sous-pixel de cet écran.

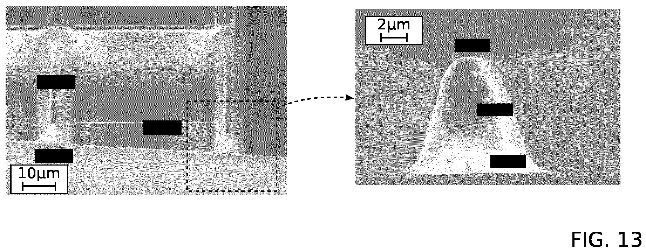

La figure 13 montre des images des cavités à parois incurvées fabriquées selon la présente invention, prises par microscopie électronique à balayage. L'image de gauche montre à titre d'exemple une coupe transversale d'une cavité. L'image de droite montre une vue rapprochée d'une paroi qui sépare deux cavités voisines, selon cet exemple. Ces images montrent clairement que le procédé proposé offre une solution particulièrement efficace pour former des motifs à parois incurvées, notamment des cavités à parois incurvées.

L'invention n'est pas limitée aux modes de réalisations précédemment décrits et s'étend à tous les modes de réalisation couverts par l'invention. Bien d'autres variantes de réalisation sont possibles, par exemple par combinaison de caractéristiques précédemment décrites, sans sortir du cadre de l'invention. En outre, les caractéristiques décrites relativement à un aspect de l'invention peuvent être combinées à un autre aspect de l'invention.

## Revendications

1. Procédé de fabrication par lithographie défocalisée, d'un empilement (1) comprenant au moins un motif (20, 20') délimité au moins en partie par une paroi latérale incurvée de sorte qu'une intersection de la paroi incurvée avec un plan sensiblement perpendiculaire au plan d'extension principale de l'empilement (1) forme une ligne courbe, le procédé comprenant :
• une fourniture d'un ensemble multicouche (1a) comprenant un substrat (S) surmonté d'une couche photosensible (10), la couche photosensible (10) présentant une surface exposée (10a) et étant à base d'une résine photosensible comprenant des particules dites « diffusantes », aptes à diffuser un rayonnement lumineux incident (2),
• une fourniture d'un masque (30) comprenant au moins une région (40) transparente configurée pour transmettre le rayonnement lumineux incident (2),
• un placement du masque (30) et de l'ensemble multicouche (1a) de façon à les espacer d'une distance D1 configurée de sorte que la surface exposée (10a) de la couche photosensible (10) ne soit pas disposée dans un plan de focalisation (3) du rayonnement lumineux incident (2),
• le masque (30) et l'ensemble multicouche (1a) étant séparés par la distance D1, une insolation d'au moins une partie de la couche photosensible (10) par le rayonnement lumineux incident (2) transmis à travers l'au moins une région (40) transparente, dans laquelle le rayonnement lumineux incident (2) est diffusé latéralement par les particules au fur et à mesure d'une pénétration du rayonnement lumineux incident (2) dans la couche photosensible (10), de façon à former au moins une région insolée (11) délimitée au moins en partie par une paroi latérale incurvée, et au moins une région non-insolée (12),
• une formation de l'au moins un motif (20, 20') dans l'ensemble multicouche (1a), la formation comprenant un retrait de l'une parmi la région insolée (11) et la région non-insolée (12), pour obtenir l'empilement (1).

2. Procédé selon la revendication précédente, dans lequel la distance D1 est strictement supérieure à une distance entre le masque (30) et le plan de focalisation (3), ladite distance D1 étant choisie de sorte que la surface exposée (10a) soit écartée du plan de focalisation (3) d'une distance D2 comprise entre 100 nm et 100 µm.

3. Procédé selon l'une quelconque des revendications précédentes, dans lequel les particules diffusantes sont choisies parmi le groupe constitué de : des oxydes de métaux de formule MₓO_{y}, avec x, y des entiers positifs non nuls, tels que le dioxyde de titane (TiO₂), l'oxyde de zinc (ZnO), l'oxyde de manganèse (MnO), les oxydes de lanthanides (Ln₂O₃), l'oxyde d'aluminium (Al₂O₃), l'oxyde de magnésium (MgO), l'oxyde de silicium (SiOz), les oxydes de fer (FeₓO_{y}), l'oxyde de zirconium (ZrO₂), et des nanoparticules à base d'au moins un métal tel que l'argent (Ag), l'or (Au), le platine (Pt), le nickel (Ni), l'aluminium (AI) ou le chrome (Cr).

4. Procédé selon l'une quelconque des revendications précédentes, dans lequel la couche photosensible (10) est à base d'une résine photosensible négative, de sorte que, lors de la formation de l'au moins un motif (20, 20'), le retrait de la région non-insolée (12) induise la formation d'au moins une cavité (20) délimitée au moins en partie par ladite paroi latérale incurvée.

5. Procédé selon l'une quelconque des revendications précédentes, dans lequel la résine photosensible présente une proportion massique de particules diffusantes comprise entre 1% et 40%, de préférence entre 3% et 20%.

6. Procédé selon l'une quelconque des revendications précédentes, dans lequel les particules diffusantes présentent une réflectivité comprise entre 20% et 100%, de préférence entre 75% et 100%.

7. Procédé selon l'une quelconque des revendications précédentes dans lequel la couche photosensible (10) comprend plusieurs sous-couches (15, 16, 17) au moins en partie superposées, chaque sous-couche (15, 16, 17) présentant une proportion massique en particules diffusantes distincte entre les plusieurs sous-couches (15, 16, 17), la proportion massique augmentant entre deux sous-couches superposées en s'éloignant de la surface exposée (10a).

8. Procédé selon l'une quelconque des revendications précédentes, dans lequel l'au moins une région insolée (11) est soumise à une dose d'insolation comprise entre 50 mJ/cm² et 3000 mJ/cm².

9. Procédé selon l'une quelconque des revendications précédentes en combinaison avec la revendication 4, dans lequel, la couche photosensible étant à base d'une résine photosensible négative, le substrat (S) de l'empilement (1) est surmonté d'au moins une diode électroluminescente (50) disposée à l'interface entre le substrat (S) et la couche photosensible (10), et l'insolation est configurée de sorte que la cavité (20) expose au moins en partie l'au moins une diode électroluminescente (50).

10. Procédé selon la revendication précédente, comprenant, après la formation de l'au moins une cavité (20), le dépôt d'une solution (60) comprenant des modules de conversion de couleur dans l'au moins une cavité (20) exposant l'au moins une diode électroluminescente (50), l'au moins une diode électroluminescente étant configurée pour émettre un rayonnement lumineux présentant une première longueur d'onde, les modules de conversion de couleur étant configurés pour convertir la première longueur d'onde en une deuxième longueur d'onde distincte de la première longueur d'onde,
de préférence la solution (60) comprenant des modules de conversion de couleur comprend en outre des particules diffusantes aptes à diffuser un rayonnement émis par l'au moins une diode électroluminescente (50), ladite solution (60) présentant une proportion massique en particules diffusantes inférieure à une proportion massique des particules diffusantes dans la couche photosensible (10).

11. Empilement (1) **caractérisé en ce qu'**il comprend :
• un substrat (S) surmonté d'une couche photosensible (10) à base d'une résine photosensible comprenant des particules aptes à diffuser un rayonnement lumineux incident (2) présentant un premier pourcentage massique,
• la couche photosensible (10) comprenant au moins un motif (20, 20') délimité au moins en partie par une paroi latérale incurvée de sorte qu'une intersection de la paroi latérale incurvée avec un plan sensiblement perpendiculaire au plan d'extension principale de l'empilement (1) forme une ligne courbe, la couche photosensible (10) présentant une surface exposée (10a), et l'au moins un motif (20, 20') débouchant sur la surface exposée (10a), l'au moins un motif (20, 20') présentant, dans le plan d'extension principale de l'empilement (1), une section transversale croissante le long d'une direction perpendiculaire au plan d'extension principale de l'empilement (1) en s'éloignant du substrat (S),
de préférence l'au moins un motif (20, 20') présente une profondeur comprise entre 5 µm et 30 µm.

12. Empilement (1) selon la revendication précédente, dans lequel l'au moins un motif (20, 20') est au moins une cavité (20) délimitée au moins en partie par ladite paroi latérale incurvée.

13. Dispositif optoélectronique (100) comprenant l'empilement (1) selon l'une quelconque des deux revendications précédentes, et au moins une diode électroluminescente (50), dans lequel le motif (20, 20') surmonte la diode électroluminescente (50).

14. Dispositif optoélectronique selon la revendication précédente, dans lequel l'au moins un motif (20, 20') est au moins une cavité (20) délimitée au moins en partie par ladite paroi latérale incurvée, et l'au moins une diode électroluminescente (50) est disposée dans l'au moins une cavité (20), ladite cavité (20) étant configurée de sorte à exposer au moins en partie la diode électroluminescente (50).

15. Dispositif optoélectronique (100) selon la revendication précédente, comprenant une solution (60) dans l'au moins une cavité (20), la solution (60) comprenant des modules de conversion de couleur et des particules diffusantes, ladite solution (60) présentant une proportion massique en particules diffusantes inférieure à une proportion massique des particules diffusantes dans la couche photosensible (10), l'au moins une diode électroluminescente étant configurée pour émettre un rayonnement lumineux présentant une première longueur d'onde, les modules de conversion de couleur étant configurés pour convertir la première longueur d'onde en une deuxième longueur d'onde distincte de la première longueur d'onde.
de préférence le dispositif comprend au moins trois diodes électroluminescentes (50) configurées pour émettre un rayonnement lumineux présentant une première longueur d'onde, et disposées de sorte que :
• une première diode électroluminescente (50) est disposée dans une première cavité (20) comprenant une première solution (60), la première solution (60) comprenant des premiers modules de conversion de couleur et des particules diffusantes, les premiers modules de conversion de couleur étant configurés pour convertir la première longueur d'onde du rayonnement lumineux émis par la première diode électroluminescente (50) en une deuxième longueur d'onde différente de la première longueur d'onde,
• une deuxième diode électroluminescente (50) est disposée dans une deuxième cavité (20) comprenant une deuxième solution (60), la deuxième solution (60) comprenant des deuxièmes modules de conversion de couleur et des particules diffusantes, les deuxièmes modules de conversion de couleur étant configurés pour convertir la première longueur d'onde du rayonnement lumineux émis par la deuxième diode électroluminescente (50) en une troisième longueur d'onde différente des premières et deuxièmes longueurs d'onde,
• une troisième diode électroluminescente (50) est disposée dans une troisième cavité (20) comprenant une troisième solution (60), la troisième solution (60) comprenant des particules diffusantes.
